# EUROPEAN PATENT SPECIFICATION

(11) **EP 2 979 362 B1**
(45) Date of publication and mention of the grant of the patent: **08.05.2019**
(21) Application number: 13715172.6
(22) Date of filing: 28.03.2013
(51) Int. Cl.: H03K 17/96

(54) **CAPACITIVE TOUCH SENSORS INTERFACE IMPLEMENTATION**
IMPLEMENTIERUNG EINER SCHNITTSTELLE FÜR KAPAZITIVE BERÜHRUNGSSENSOREN
IMPLÉMENTATION D'INTERFACE DE CAPTEURS TACTILES CAPACITIFS

(43) Date of publication of application: 03.02.2016
(73) Proprietor: Arçelik Anonim Sirketi, 34950 Istanbul (TR)
(72) Inventor: YAKUT, Ufuk Levan, 34950 Istanbul (TR); IZGEN, Ovunc Doruk, 34950 Istanbul (TR); OCAK, Baris, 34950 Istanbul (TR)
(86) International application number: PCT/EP2013/056660
(87) International publication number: WO 2014/154275

(56) References cited:
- WO-A1-2009/002007
- WO-A1-2011/154378
- US-A1- 2009 260 898
- US-A1- 2011 011 717
- US-A1- 2012 312 676

## Description

The present invention relates to a household appliance with capacitive touch sensors operable in response to touch of users.

Household appliances having touch keys are of preference as they involve a more appealing look and functionality. As touch-sensitive sensors require no movable mechanical parts, they are not directly prone to wear compared to their mechanical counterparts. Unlike mechanical interfaces, touch sensitive interfaces with a plurality of touch keys can be made transparent, which is another factor, speaking in terms of physical appearance.

Yet, touch sensors are prone to certain disadvantages; namely they are susceptible to environmental conditions such as humidity and temperature.

In a more specific manner, when the finger of a user is moved near a touch sensor, other touch sensors in the vicinity thereof are also affected. The common method for eliminating or optimizing the so-called cross-talk effect involves grounding surfaces in between the touch sensors and isolating said sensors from each other accordingly. This, however, in turn results in loss of precision on the part of the touch sensors as some amount of the load inducted from the finger of the user is drawn from the touch key region by the grounding line and transferred to the ground.

The common approach briefly referred to above is therefore not practical in the event that normal environmental conditions can be ascertained, i.e. when the temperature and humidity values are within an acceptable range.

United States Patent Application US 2011/011717 A1 discloses a capacitive touch circuit with a capacitance sensor that is coupled to an adjustable resistor via which the oscillation frequency of the RC circuit can be set.

United States Patent Application US 2009/260898 A1 discloses a method for preventing a malfunction of a touch input device due to an abrupt change of external temperature. The method measures temperature change and compensates a recognition threshold value that is used for detecting a touch event by comparing said event with a measured capacitance change of the touch input device.

International Patent Application WO 2009/002007 A1 discloses a touch detection operation in which the pulse width of a pulse signal is corrected to be appropriate for a current operating environment of a touch sensor.

A prior art publication in the technical field of the present invention may be referred to as WO2011154378A1 among others, the document disclosing a household appliance comprising capacitive touch sensors that operate by sensing the touch of the user. It essentially features a control panel, more than one capacitive type touch sensor integrated to the control panel, a control unit having a drive circuit that produces voltage signals so as to generate a constant electrical field in the touch sensors and a sense circuit that evaluates the signals received from the touch sensors. A grounding shield, extending to regions remaining between the touch sensors is accordingly generated to decrease the cross-talk problem by isolating the touch sensors.

It is to be noted that the present invention, while still addressing the same technical problem, advantageously uses an improved algorithm to sense and appropriately calculate the amount of interference by the surrounding environment only when so required.

The present invention provides an arrangement as to the household appliance with capacitive touch sensors, as defined in Claim 1.

Primary object of the present invention is to provide a household appliance with capacitive touch sensors, said sensors' responsiveness being ensured under different environmental conditions.

The present invention proposes a capacitive sensor interface implementation in a household appliance. The household appliance comprises a control panel having a plurality of capacitive touch sensors associated with operational functions to be performed by said household appliance. The household appliance further comprises a control unit in electrical communication with each of said plurality of capacitive touch sensors through a conductive line.

The conductive line has a serial resistance in between said control unit and each of the plurality of capacitive touch sensors. The serial resistance is an electronically controllable variable resistance whose resistance value on said conductive line is controllable by the control unit by means of a control signal on an electronic control line.

The control unit is in electrical communication with at least one environmental parameter sensor selected from the group of a humidity sensor, a temperature sensor and an electromagnetic interference sensor. The control unit sets resistance value of a serial resistance to its minimum value in the absence of contact with a button of a touch sensor.

In the event that contact with a button of a touch sensor is sensed by the control unit, the control unit evaluates amount of fluctuations in signals received from the touch sensor and sets resistance value of a serial resistance associated with the touch sensor to its maximum value.

On the other hand, the control unit receives input from at least one of said humidity, temperature and electromagnetic interference sensors and sets resistance value of a serial resistance to a resistance value according to a predefined table such that the resistance value of the serial resistance is calibrated in response to different environmental conditions in respect of temperature, humidity and electromagnetic interference.

Accompanying drawings are given solely for the purpose of exemplifying a capacitive sensor interface implementation in a household appliance whose advantages over prior art were outlined above and will be explained in brief hereinafter.

The drawings are not meant to delimit the scope of protection as identified in the claims nor should they be referred to alone in an effort to interpret the scope identified in said claims without recourse to the technical disclosure in the description of the present invention.

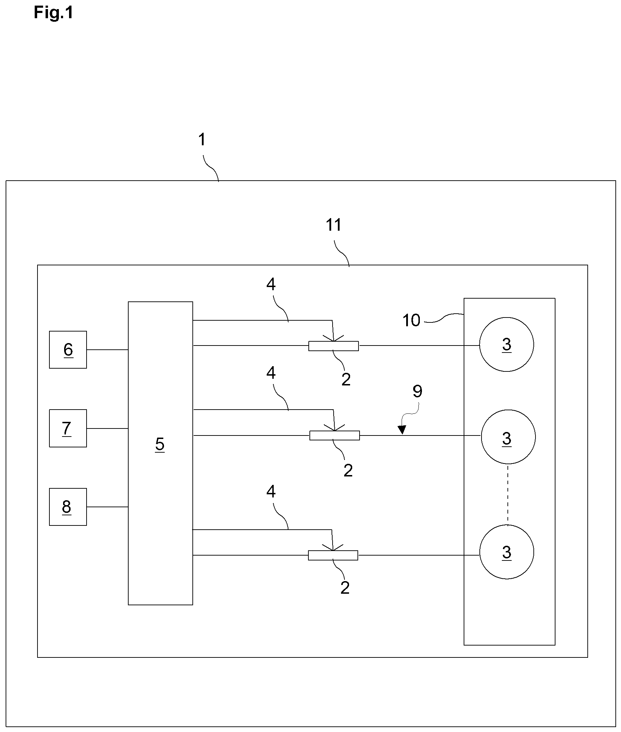

Fig. 1 demonstrates a schematic view of the capacitive sensor interface implementation in a household appliance according to the present invention.

Fig. 2 demonstrates a flow diagram of the capacitive sensor interface implementation in a household appliance according to the present invention.

The following numerals are used in this detailed description:
Household appliance (1)
Serial resistance (2)
Touch sensor (3)
Electronic control line (4)
Control unit (5)
Humidity sensor (6)
Temperature sensor (7)
Electromagnetic interference sensor (8)
Conductive line (9)
Control panel (10)
Sensor implementation circuit (11)
The present invention relates to a household appliance (1) with capacitive touch sensors (3) operable in response to touch of users, said appliance (1) having a capacitive sensor interface implementation circuit (11), allowing users to set certain parameters and/or initiate certain functions by way of touching said touch sensors (3) in the capacitive sensor interface.

The household appliance (1) of the present invention comprises a control panel (10) with a plurality of capacitive type touch sensors (3) integrated to the control panel (10). The touch sensors (3) may typically fulfill functions such as turning on, turning off of the household appliance (1) or any other auxiliary functions associated with the respective sensor that is sensing touch of a user's finger.

A control unit (5) conventionally regulates operation of the touch sensors (3) so as to produce a voltage drop on the touch sensors (3). A serial resistance (2) in between each touch sensor (3) and the control unit (5) provides a filtering effect and accordingly enhances immunity to electromagnetic interference.

It is to be noted that improved immunity to electromagnetic interference is associated with higher ohmic values of the serial resistance (2). On the other hand, higher resistance values will lead to reduced signal resolution as the amount of charges flowing through the conductive line (9) will accordingly decrease. Use of a higher ohmic resistance in normal conditions, i.e. where no humidity or temperature fluctuation is monitored or where no electromagnetic interference is in question, will cause serious performance failure and as such, signal resolution must dynamically be adjusted to environmental conditions for achieving an acceptable performance.

The capacitive sensor interface implementation according to the present invention employs a humidity sensor (6), a temperature sensor (7) and an electromagnetic interference (EMF) sensor (8), all of which being widely used in industry and also commercially available in the market. The sensors (6, 7, 8) according to the invention provide critical information in relation to the humidity, temperature and electromagnetic interference of the physical environment where the capacitive sensors (3) are disposed.

The sensor implementation circuit (11) of the present invention comprises a plurality of electronically controllable resistances in the form of electrical serial resistances (2) connected in series between the control unit (5) and individual capacitive sensors (3). An electronically controllable variable resistance can be realized in a plurality of ways involving various integrated circuits. For instance, a semiconductor resistor having a three layer construction of either an NPN-type or a PNP-type which is similar to that of a bipolar transistor can be used in this respect. The base region and collector region of the transistor can be used as a variable resistor such that its resistance value is controlled by varying its emitter current. Accordingly, a control signal can be applied on an electronic control line (4) for performing control over the electronically controllable serial resistance (2).

The sensor implementation circuit (11) of the present invention functions such that a series of decisions are taken in respect of the humidity, temperature and electromagnetic interference of the physical environment where the capacitive sensors (3) are disposed. To this end, the control unit (5) first tries to establish whether a button of a given touch sensor (3) is pressed. If no such indication is present, the control unit (5) then sets the respective resistance value to its minimum value. If, on the other hand, the control unit (5) senses contact with a given touch sensor (3), it starts evaluating whether there are any fluctuations in the signals received from the respective touch sensor (3). If there are any, it sets the respective resistance value to its maximum value.

Preferably, the control unit (5) also receives input from said humidity, temperature and electromagnetic interference sensors (6, 7, 8) and in the same time evaluate fluctuations in the amount of induced charges flowing through the conductive line (9) of the sensor (3). In the presence of additional input from said humidity, temperature and electromagnetic interference sensors (6, 7, 8), the additional data is used to calibrate the resistance value. To this end, a predefined table is used to calibrate resistance values in response to different environmental conditions in respect of temperature, humidity and electromagnetic interference. Therefore, in the presence of additional input from the environmental parameter sensors (6, 7, 8), the control unit (5) does not need to directly set the respective resistance value to its maximum value but can set a lower value as well, depending on the inputs from said environmental parameter sensors (6, 7, 8).

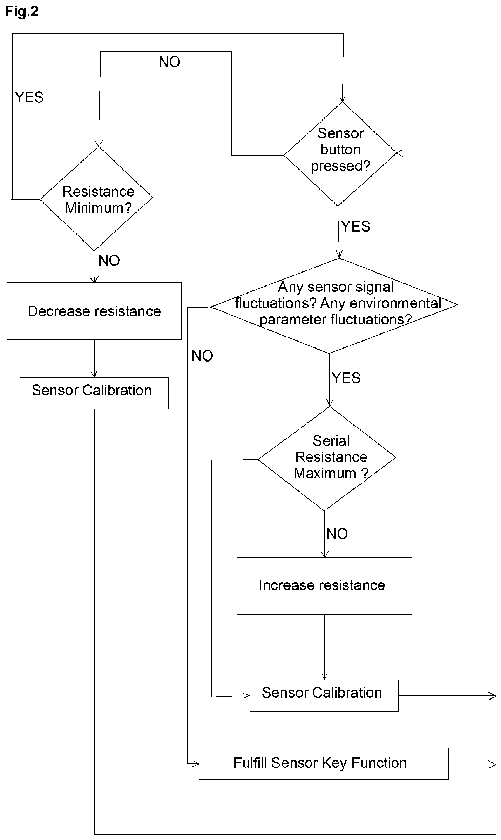

The present invention advantageously uses an improved algorithm as shown in Fig.2, to sense and appropriately calculate the amount of interference by the surrounding environment. Additionally, in the absence of special environmental parameter sensors (6, 7, 8), said control unit (5) automatically sets resistance value of a serial resistance (2) to its minimum or maximum values. Said control unit (5) sets the resistance value of a serial resistance (2) to its minimum value when no contact with a button associated with a touch sensor (3) is sensed. On the other hand, when such contact is sensed by the control unit (5), it sets the resistance value of the respective serial resistance (2) to its maximum value only when fluctuations are sensed in the signals received from the respective touch sensor (3).

## Claims

1. A household appliance (1) comprising a control panel (10) having a plurality of capacitive touch sensors (3) associated with operational functions to be performed by said household appliance (1), the household appliance (1) further comprising a control unit (5) in electrical communication with each of said plurality of capacitive touch sensors (3) through a conductive line (9), said conductive line (9) having a serial resistance (2) in between said control unit (5) and each of the plurality of capacitive touch sensors (3) and the serial resistance (2) is an electronically controllable variable resistance whose resistance value on the conductive line (9) is controllable by the control unit (5) by means of a control signal on an electronic control line (4) wherein the control unit (5) is programmed to sense if a capacitive touch sensor among the plurality of capacitive touch sensors is pressed (3) and if said capacitive touch sensor is pressed, to evaluate an amount of fluctuations in signals received from said capacitive touch sensor (3) and to set a resistance value of a serial resistance (2) associated with said capacitive touch sensor (3) to its maximum value if such fluctuations are not within a predefined limit.

2. A household appliance (1) as in Claim 1, **characterized in that** the control unit (5) is in electrical communication with at least one environmental parameter sensor selected from the group of a humidity sensor (6), a temperature sensor (7) and an electromagnetic interference sensor (8).

3. A household appliance (1) as in Claim 1 or 2, **characterized in that** the control unit (5) is programmed to set the resistance value of the serial resistance (2) associated with the capacitive touch sensor to its minimum value in the absence of contact with said capacitive touch sensor (3).

4. A household appliance (1) as in Claim 2, **characterized in that** the control unit (5) is programmed to receive input from at least one of said humidity, temperature and electromagnetic interference sensors (6, 7, 8) and to set the resistance value of a serial resistance (2) to a resistance value according to a predefined table such that the resistance value of the serial resistance (2) is calibrated in response to different environmental conditions in respect of temperature, humidity and electromagnetic interference.

## Patentansprüche

1. Ein Haushaltsgerät (1) umfasst einen Bedienfeld (10) mit mehreren kapazitiven Berührungssensoren (3), die den Betriebsfunktionen zuzuordnen sind, die vom Haushaltsgerat (1) aus führen. Des Weiteren besitzt das Haushaltsgerät (1) eine Steuereinheit (5), die in elektrischer Verbindung mit den kapazitiven Berührungssensoren (3) über eine leitfähige Leitung (9), steht, wobei die leitfähige Leitung (9) einen seriellen Widerstad (2) zwischen der Steuereinheit (5) und den kapazitiven Berührungssensoren (3) darstellt. Der seriell variable Widerstand (2) ist elektronische steuerbar und dessen variabler Widerstandswert wird auf der Leitung (9) von der Steuereinheit (5) mithilfe eines Steuersignals erfasst. Die Leitung (4), die in die Steuereinheit (5) programmiert ist, um zu erfassen, ob ein kapazitiver Berührungssensor (3) aus der Vielzahl gedrückt wird und um Schwankungen in den von dem kapazitiven Berührungssensor (3) empfangenen Signale auszuwerten und einen Widerstandswert eines seriellen Widertands (2) festzulegen, der dem kapazitiven Berührungssensor (3) zugeordnet ist und auf seinem Maximalwert zu erkennen ist, ob Schwankungen nicht innerhalb einer vordefinierten Grenzbereich liegen.

2. Ein Haushaltsgerät (1), wie in Anspruch 1 aufgeführt, **ist dadurch gekennzeichnet, dass** die Steuereinheit (5) mit mindestens einem Umgebungsparametersensor, der aus der Gruppe eines Feuchtigkeitssensor (6) ausgewählt ist und mit einem Temperatursensor (7) und einem elektromagnetischen Störungssensor (8) in Verbindung steht.

3. Ein Haushaltsgerät (1), wie in Anspruch 1 oder 2 aufgeführt, **ist dadurch gekennzeichnet, dass** die Steuereinheit (5) so programmiert ist, dass sie den Widerstandswert des seriellen Widerstands (2), der dem kapazitiven Berührungssensor zugeordnet ist, auf seinen minimalen Wert einstellt, ohne ein Kontakt mit dem kapazitiven Berührungssensor (3) zu haben.

4. Ein Haushaltsgerät (1), wie in Anspruch 2 aufgeführt, **ist dadurch gekennzeichnet, dass** die Steuereinheit (5) so programmiert ist, dass sie Eingaben von mindestens einem der Feuchtigkeits-, Temperatur- und elektromagnetischen Interferenzsensoren (6, 7, 8) empfangen kann und den Widerstandswert eines Serienwiderstands (2) auf einen Widerstandswert gemäß einer vordefinierten Tabelle einstellen kann, so dass der Widerstandswert des Serienwiderstands (2) in Reaktion auf verschiedene Umgebungsbedingungen, bezüglich Temperatur, Feuchtigkeit und elektromagnetische Interferenz kalibriert kann.

## Revendications

1. Un appareil électroménager (1) comprenant un panneau de commande (10) ayant une pluralité de capteurs tactiles capacitifs (3) associés à des fonctions opérationnelles devant être exécutées par ledit appareil électroménager (1), l'appareil électroménager (1) comprenant en outre une unité de commande (5) en communication électrique avec chacun de ladite pluralité de capteurs tactiles capacitifs (3) via une ligne conductrice (9), ladite ligne conductrice (9) ayant une résistance en série (2) entre ladite unité de commande (5) et chacun de la pluralité des capteurs tactiles capacitifs (3) et la résistance en série (2) est une résistance variable commandable électroniquement dont la valeur de résistance sur la ligne conductrice (9) peut être commandée par l'unité de commande (5) au moyen d'un signal de commande sur une ligne électronique (4), l'unité de commande (5) étant programmée pour détecter si un capteur tactile capacitif parmi la pluralité de capteurs tactiles capacitifs est enclenché (3) et si ledit capteur tactile capacitif est déclenché, pour évaluer une quantité de fluctuations dans les signaux reçus dudit capteur tactile capacitif (3) et pour régler une valeur de résistance d'une résistance en série (2) associée audit capteur tactile capacitif (3) à sa valeur maximale si de telles fluctuations ne sont pas dans une limite prédéfinie.

2. Un appareil électroménager (1) selon la déclaration 1, **est caractérisé en ce que** l'unité de commande (5) est en communication électrique avec au moins un capteur de paramètres d'environnement choisi dans le groupe constitué par un capteur d'humidité (6), un capteur de température (7) et un capteur de perturbations électromagnétiques (8).

3. Un appareil électroménager (1) selon la déclaration 1 ou 2, **est caractérisé en ce que** l'unité de commande (5) est programmée pour régler la valeur de résistance de la résistance en série (2) associée au capteur tactile capacitif à sa valeur minimale en l'absence de contact avec ledit capteur tactile capacitif (3).

4. Un appareil électroménager (1) selon la déclaration 2, **est caractérisé en ce que** l'unité de commande (5) est programmée pour recevoir une entrée provenant d'au moins un desdits capteurs d'humidité, de température et d'interférence électromagnétique (6, 7, 8) et pour régler la valeur de résistance d'une résistance en série (2) à une valeur de résistance selon un tableau prédéterminé, de sorte que la valeur de résistance de la résistance en série (2) soit calibrée en fonction de différentes conditions environnementales en matière de température, humidité et interférence électromagnétique.
